# EUROPÄISCHE PATENTSCHRIFT

(11) **EP 1 730 767 B1**
(45) Veröffentlichungstag und Bekanntmachung des Hinweises auf die Patenterteilung: **23.09.2009**
(21) Anmeldenummer: 05733613.3
(22) Anmeldetag: 24.03.2005
(51) Int. Cl.: H01L 21/00

(54) **VORRICHTUNG ZUR VEREINZELUNG UND POSITIONIERUNG VON MODULBRÜCKEN**
DEVICE FOR SEPARATING AND POSITIONING MODULE BRIDGES
DISPOSITIF DE SEPARATION ET DE POSITIONNEMENT DE PONTS MODULES

(30) Priorität: 01.04.2004 DE 102004015994
(43) Veröffentlichungstag der Anmeldung: 13.12.2006
(73) Patentinhaber: Mühlbauer AG, 93426 Roding (DE)
(72) Erfinder: KUNZE, Wolfram, 02826 Görlitz (DE); KIES, Doris, 01239 Dresden (DE); PÖNITZ, Volker, 01109 Dresden (DE); BERGMANN, Dieter, 01217 Dresden (DE)
(74) Vertreter: Hannke, Christian
(86) Internationale Anmeldenummer: PCT/EP2005/051353
(87) Internationale Veröffentlichungsnummer: WO 2005/096349

(56) Entgegenhaltungen:
- WO-A-03/012734
- US-A- 5 152 390
- US-A1- 2003 136 087
- PATENT ABSTRACTS OF JAPAN Bd. 2002, Nr. 06, 4. Juni 2002 (2002-06-04) -& JP 2002 037211 A (UENO SEIKI KK), 6. Februar 2002 (2002-02-06)
- PATENT ABSTRACTS OF JAPAN Bd. 2003, Nr. 05, 12. Mai 2003 (2003-05-12) -& JP 2003 023019 A (TOKYO WELD CO LTD), 24. Januar 2003 (2003-01-24)

## Beschreibung

Die Erfindung betrifft eine Vorrichtung zur Vereinzelung von in einem Modulbrückenband oder Modulbrückenverbund angeordneten Modulbrücken und zur Positionierung der vereinzelten Modulbrücken auf einem Auflageelement gemäß dem Oberbegriff des Patentanspruches 1.

WO 03/012734 A1 offenbart ein Verfahren zum Verbinden von Mikrochipmodulen mit auf einem ersten Trägerband angeordneten Antennen zum Herstellen eines Transponders.

Modulbrücken, die als Interposer in Form eines Interposerbandes beziehungsweise Modulbrückenbandes reihenartig angeordnet vorliegen, sind bisher mittels einer Trennvorrichtung derart geschnitten worden, dass sich die Modulbrücken aus dem Modulbrückenband vereinzelt herauslösten. Anschließend werden die Modulbrücken mittels einer weiteren Einrichtung über einem stehenden Auflageelement positioniert und durch eine abwärts gerichtete Verschiebebewegung dieser Einrichtung einzeln auf dem angehaltenen Auflageelement abgelegt. Alternativ kann die Positionierungseinrichtung ohne Abwärtsbewegung oberhalb des Auflageelementes gehalten werden, während sich das Auflageelement mittels einer Aufwärtsverschiebebewegung zu der festgehaltenen Modulbrücke hinbewegt.

Nach Ablegen einer Modulbrücke auf dem Auflageelement wird das Auflageelement um einen vorbestimmten Streckenabschnitt in seiner Laufrichtung weiterbewegt, um an einem neuen Ort eine weitere Modulbrücke aufnehmen zu können.

Derartige Vorrichtungen erfordern das Anhalten des Auflageelementes während der Ablage einer Modulbrücke auf diesen. Dadurch wird der Durchsatz einer Bestückungsvorrichtung, die derartige Vorrichtungen beinhaltet, reduziert. Zudem erfordert das getrennte Anordnen von der Trennvorrichtung und der Positionierungsvorrichtung ein erneutes Ausrichten der Modulbrücke bei der Aufnahme einer abgetrennten Modulbrücke durch die Positionierungsvorrichtung.

Demzufolge liegt der vorliegenden Erfindung die Aufgabe zugrunde, eine Vorrichtung zur Vereinzelung und einer sich anschließenden gegenüber einem Auflageelement stattfindenden Positionierung von Modulbrücken aus einem Modulbrückenband zur Verfügung zu stellen, die einen höheren Durchsatz bei einem Vorgang des Bestückens von Modulbrücken ermögl icht.

Diese Aufgabe wird gemäß den Merkmalen des Patentanspruches 1 gelöst.

Ein wesentlicher Punkt der Erfindung liegt darin, dass bei einer Vorrichtung zur Vereinzelung von in einem Modulbrückenband oder Modulbrückenverbund angeordneten Modulbrücken und zur Positionierung der vereinzelten Modulbrücken auf einem Auflageelement eine Trenneinrichtung zum Trennen des Modulbrückenbandes in dessen Randbereichen zwischen jeweils zwei Modulbrücken sowie ein Bestückungsrad zum vereinzelten Aufnehmen der abgetrennten Modulbrücken an dessen Umfangsrandseite angeordnet ist, wobei das Bestückungsrad zum Ablegen der Modulbrücken auf das sich bewegende Auflageelement nach einer durchgeführten Drehbewegung des Bestückungsrades um eine parallel zur Modulbrückenebene ausgerichtete Achse vorgesehen ist. Durch eine derartige Vorrichtung können Modulbrückenbänder, die derart perforiert sind, dass sie lediglich in ihren Randbereichen zwischen den Modulbrücken noch Haltestege aufweisen, in einem fortlaufenden Arbeitsablauf zur Vereinzelung der Modulbrücken geschnitten werden und anschließend durch das Bestückerrad, dessen Drehgeschwindigkeit einer Geschwindigkeit des Auflageelementes angepasst wird, auf dem sich bewegenden Auflageelement, welches beispielsweise bandartig ausgebildet sein kann, abgelegt werden. Eine solche Bestückung des Auflageelementes erfordert also für die Positionierung der Modulbrücke kein Anhalten des Auflageelementes, woraus sich ein erhöhter Durchsatz einer Bestückungsvorrichtung ergibt.

Da das perforierte Modulbrückenband zwischen den Modulbrücken Durchgangsöffnungen, vorzugsweise Löcher aufweist, die zum Eingreifen von Stiften oder Stegen, für den Transport des Modulbrückenbandes auf einer Zuführeinheit zu der Trenneinrichtung hin dienen, kann eine genaue Ausrichtung des Modulbrückenbandes im Bereich eines Schneidemessers erreicht werden. Auf diese Weise erübrigt sich die Anordnung einer bisher üblichen Erfassungskamera zur Ausrichtung des Modulbrückenbandes und der anschließend vereinzelten Modulbrücken.

Gemäß einer bevorzugten Ausführungsform weist das Bestückungsrad an seiner Umfangsrandseite voneinander beabstandete, vorzugsweise federbeaufschlagte als Mitnehmer ausgebildete Arretierungselemente zum Arretieren einzelner Modulbrücken auf der Umfangsrandseite auf. Diese Arretierungselemente dienen zudem zum Ausrichten der vereinzelten Modulbrücken auf dem Bestückungsrad und gegenüber dem Auflageelement, auf welchem sie abschließend abgelegt werden.

Das Bestückungsrad weist an seine Umfangsrandseite eine Breitenabmessung auf, die einer Längenabmessung einer Modulbrücke entspricht, sodass mittels zusätzlicher Führungselemente, die an einem komplementär zu der Umfangsrandseite des Bestückungsrades ausgebildeten und an dieser anliegenden Bremsklotz einer Bremseinrichtung angeordnet sind, ein seitliches Führen und zugleich Ausrichten der Modulbrücken während der Drehbewegung des Bestückungsrades möglich ist.

Vorzugsweise ist das Bestückungsrad derart ausgebildet, dass es an seiner Umfangsrandseite zumindestens in dem Bereich, in dem die Modulbrücken aufgenommen sind, zwischen einem linksseitig und einem rechtsseitig angeordneten Steg Ausnehmungen zur Aufnahme von auf den Modulbrücken angeordneten Bauelementen aufweist. Somit ist eine Beschädigung der Bauelemente bei einem Auffliegen der Modulbrücken auf der Umfangsrandseite ausgeschlossen.

Die Trenneinrichtung beinhaltet das senkrecht zur Modulbrückenbandebene verschiebbare Schneidmesser zum Durchtrennen des Modulbrückenbandes in dessen Randbereichen, nachdem es über die Zuführeinheit taktweise um jeweils einen Weg, der der Breite einer Modulbrücke entspricht, dem Schneidmesser zugeführt worden ist.

Um einen sauberen Schnitt mittels des Schneidemessers ohne Verschieben des Modulbrückenbandes zu ermöglichen, weist die Trenneinrichtung einen Druckstempel zum Andrücken des Modulbrückenbandes auf eine Oberfläche der Zuführeinheit auf.

Zudem kann die Zuführeinheit Führungselemente zur seitlichen Führung des Modulbrückenbandes beinhalten.

Nachdem das Schneidmesser das Modulbrückenband durchtrennt hat, wird die gesamte Trenneinrichtung während einer weiteren Vorwärtsbewegung des Schneidmessers gegenüber dem Bestückungsrad gekippt, sodass ein Abstand zwischen dem restlichen Modulbrückenband und der abgetrennten Modulbrücke, die von dem Bestückungsrad aufgenommen wird, geschaffen wird.

Zwischen der Trenneinrichtung und dem Auflageelement ist die an einem Teil der Umfangsrandseite des Bestückungsrades anliegende Bremseinrichtung mit dem Bremsklotz zum Bremsen des sich drehenden Bestückungsrades angeordnet. Die Bremseinrichtung sorgt im Zusammenspiel mit einem das Bestückungsrad antreibenden Motor dafür, dass das Bestückungsrad nach Aufnahme einer Modulbrücke auf die Drehgeschwindigkeit beschleunigt wird, deren Umfangsgeschwindigkeit der Geschwindigkeit des sich fortlaufend bewegenden Auflageelementes entspricht.

Die Bremseinrichtung ist zusätzlich mit einem Heizelement zum Erwärmen von Kontaktklebestellen der Modulbrücken, die auf dem Bestückungsrad angeordnet sind, ausgestattet, sodass ein auf den Modulbrücken angeordneter Klebstoff aktiviert wird, um anschließend mit dem Auflageelement eine Klebeverbindung einzugehen.

Der Bremsklotz weist vorzugsweise zwei randseitig verlaufende Bremsbelege auf, gegen welche zwei komplementär ausgebildete auf der Umfangsrandseite des Bestückungsrades angeordnete Andrückelemente drückbar sind, wobei zwischen den Andrückelementen und den Bremsbelägen die Modulbrücken angeordnet sind. Somit ist eine zuverlässige zusätzliche Fixierung der auf dem Bestückungsrad vorhandenen Modulbrücken während seiner Drehbewegung möglich.

Um die einzelnen Modulbrücken auf dem Auflageelement zu fixieren, ist auf der dem Bestückungsrad entgegengesetzten Seite des Auflageelementes eine Gegenrolle angeordnet, die gegen das Bestückungsrad mit dazwischenliegendem Auflageelement und Modulbrücke drückt

Weitere vorteilhafte Ausführungsformen ergeben sich aus den Unteransprüchen.

Vorteile und Zweckmäßigkeiten sind der nachfolgenden Beschreibung in Verbindung mit der Zeichnung zu entnehmen. Hierbei zeigen:
- Fig. 1: in einer perspektivischen Ansicht ein bereits perforiertes Interposerband zur Verwendung in einer erfindungsgemäßen Vorrichtung;
- Fig. 2: in einer perspektivischen Ansicht eine Vorrichtung zum Vereinzeln und Positionieren von Modulbrücken gemäß einer Ausführungsform der Erfindung;
- Fig. 3: in einer Draufsicht die in Fig. 2 gezeigte Vorrichtung gemäß einer Ausführungsform der Erfindung;
- Fig. 4: in einer perspektivischen Ansicht ein Bestückungsrad mit einer Bremseinrichtung für die erfindungsgemäße Vorrichtung;
- Fig. 5: in einer perspektivischen Ansicht eine Bremseinrichtung mit einem Interposerband für die erfindungsgemäße Vorrichtung;
- Fig. 6: in einer perspektivischen Darstellung eine Vorrichtung gemäß einer weiteren Ausführungsform der Erfindung.

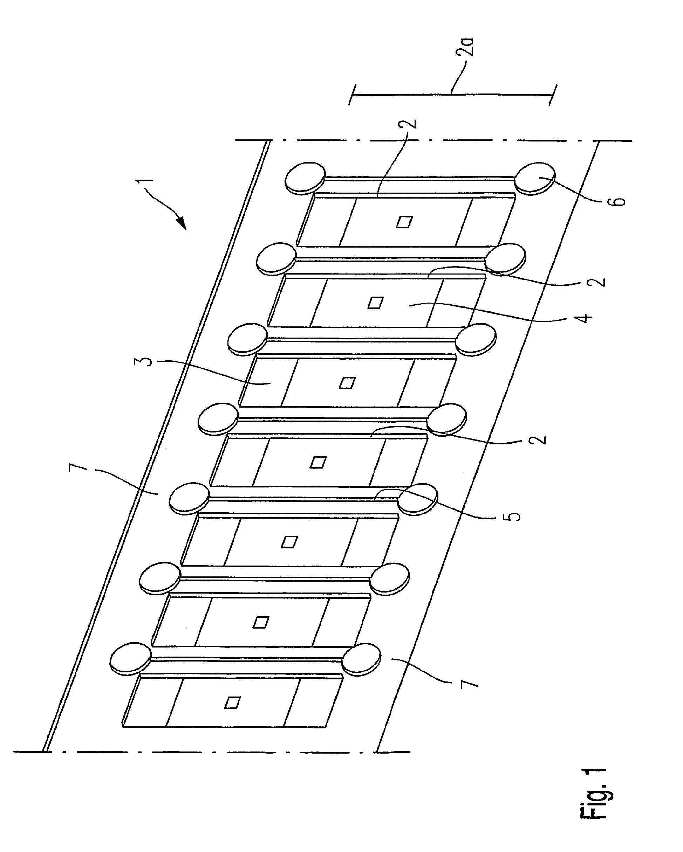

In Fig. 1 wird in einer perspektivischen Darstellung ein Interposerband 1 gezeigt, wie es in der erfindungsgemäßen Vorrichtung verwendet werden kann. Das Interposerband 1 weist reihenartig angeordnete Interposer 2 mit einer Längenabmessung 2a auf, wobei die Interposer links- und rechtsseitig zwei Kontaktklebeflächen 3 aufzeigen. Zwischen den Kontaktklebeflächen 3 sind Bauteile 4 angeordnet.

Ein derartiges einreihiges Interposerband 1, welches auch als Mehrspurband ausgebildet sein kann, ist derart perforiert, dass es zwischen den Interposerschnitt und -transportkanten 5 Perforationslöcher 6 aufweist. Auf diese Weise bestehen in dem Randbereich des Interposerbandes 1 Haltestege 7, die die einzelnen Interposer 2 zu dem Interposerband 1 zusammenhalten.

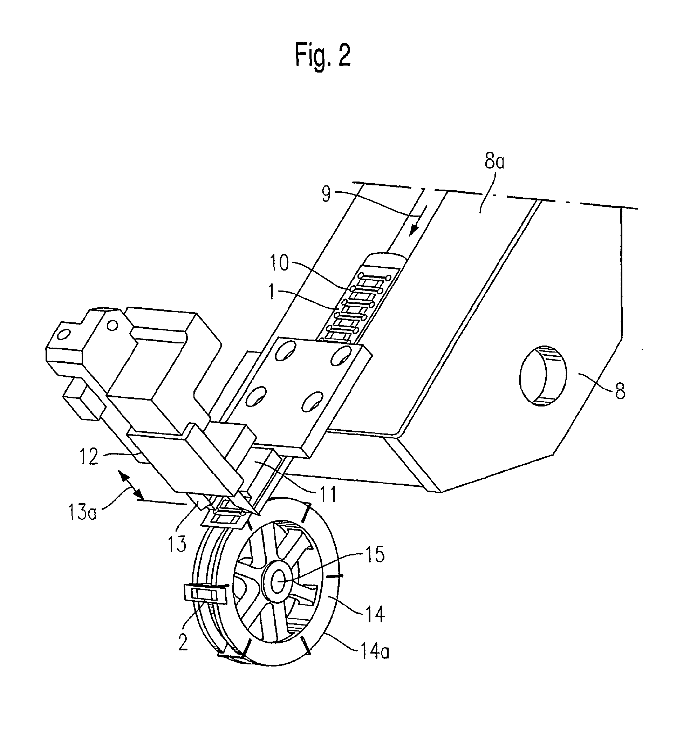

In Fig. 2 wird in einer perspektivischen Darstellung die erfindungsgemäße Vorrichtung gezeigt. Wie der Fig. 2 zu entnehmen ist, wird auf einer Zuführeinheit 8 mit einer Oberfläche 8a entlang der Pfeilrichtung 9 das Interposerband 1 mittels darin eingreifender Stege 10 in Richtung einer Schneideeinrichtung 12 taktweise bewegt. Sobald das Interposerband 1 die Weglänge einer Modulbrückenbreite zurückgelegt hat, drückt ein Druckstempel von oben zur Fixierung während des Schneidvorganges auf das Interposerband.

Anschließend findet eine Verschiebung eines Schneidemessers 13 bzw. von Schneidrollen statt, wie es durch den Doppelpfeil 13a angedeutet wird. Das sich nach unten bewegende Schneidemesser 13 trennt den hervorstehenden Interposer von dem Interposerband 1 ab. Hierfür ist das Schneidemesser 13 derart ausgebildet, dass es lediglich die randseitig angeordneten Haltestege 7 des Interposerbandes 1 durchtrennt. Der restliche Bandbereich zwischen den Interposem ist bereits während des Perforationsvorganges durchtrennt worden. Auf diese Weise verringern sich die aufzuwendenden Schnittkräfte.

Anschließend bewegt sich das Schneidemesser 13 weiterhin abwärts, während die gesamte Schneideeinrichtung 12 gegenüber dem Bestückungsrad gekippt wird, um auf diese Weise eine Lücke zwischen dem restlichen Interposerband und dem abgeschnittenen Interposer zu schaffen.

Die Schneidmesser sind derart gestaltet, dass die Schnittkräfte während des Trennvorganges der Haltestege 7 nach innen, also zur Bandmitte hin wirken, um so eine Gratbildung am Außenrand des Interposers zu vermeiden.

Ein Bestückungsrad 14 nimmt an seiner Umfangsrandseite 14a den vereinzelten Interposer 2 mittels Mitnehmerkrallen auf und dreht sich um eine Achse 15.

Das Bestückungsrad 14 weist eine Breite auf, die geringer als der Zwischenraum zwischen den zweitteilig ausgebildeten Schneidemessern ist, sodass während des Schneidvorganges und des Kippvorganges die Schneidemesser 13 rechts und links am Bestückungsrad vorbeibewegt 14 werden.

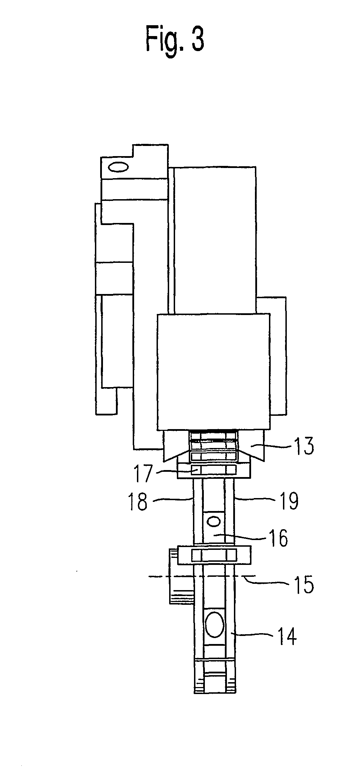

In Fig. 3 wird in einer Draufsicht die in Fig. 2 gezeigte Ausführungsform der Vorrichtung gezeigt. Das Bestückerrad weist in vorbestimmten Abschnitten an seiner Umfangsrandseite Mitnehmerkrallen 16 auf, die zur Fixierung der Interposer 2 auf dem Bestückerrad dienen. Derartige Mitnehmerkrallen sind mit einem Federelement ausgestattet und dienen zur Übernahme der vereinzelten Interposer nach deren Abtrennung von dem Interposerband 1.

Die Breite des Bestückungsrades 14 entspricht einer Längenabmessung 2a eines Interposers, vorzugsweise einer Längenabmessung der Transportkante 5.

Das Bestückungsrad 14 weist zwei randseitig umlaufende Stege 18 und 19 auf, auf welchen die Interposer aufliegen. Zwischen diesen Stegen sind Ausnehmungen angeordnet, die zur Aufnahme der auf den Interposem angeordneten Bauteile dienen.

Die Stege 18, 19 können als Andrückelemente für die Fixierung von Befestigungspunkten 17, die den Klebeflächen 3 entsprechen, auf dem sich bewegenden Auflageelement verwendet werden.

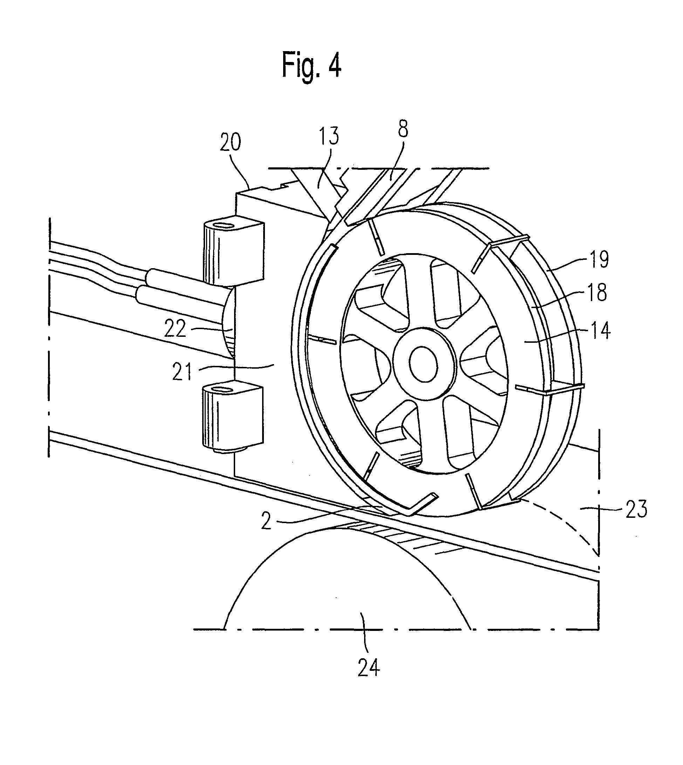

In Fig. 4 wird in einer perspektivischen Darstellung ein das Bestückungsrad mit einer Bremseinrichtung für die erfindungsgemäße Vorrichtung gezeigt. Die Bremsvorrichtung 20 weist einen Bremsklotz 21 auf, der komplementär zu der Umfangsrandseite 14a des Bestückungsrades 14 ausgebildet ist. Zudem ist in der Bremseinrichtung ein Heizelement 22 eingebaut, welches durch Wärmeleitung bzw. Wärmestrahlung die Klebefläche 3 an einem Befestigungspunkt 17 der Interposer 2 aktiviert.

Sobald das Bestückungsrad 14 eine Drehgeschwindigkeit im Zusammenspiel mit der Bremseinrichtung 20 erreicht hat, die einer Geschwindigkeit eines Auflageelementes 23 entspricht, wird der Interposer 2 auf dem Auflageelement abgelegt und mittels einer Gegenrolle 24 durch Druck und Aktivierung der Klebeflächen fixiert.

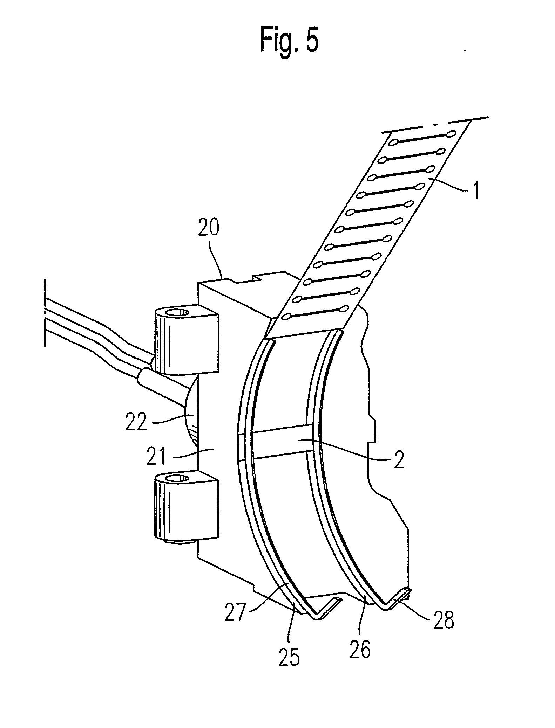

In Fig. 5 wird die Bremseinrichtung mit dem Interposerband 1 in einer perspektivischen Darstellung gezeigt. Der Bremsklotz 21 weist links- und rechtsseitig verlaufende Bremsbeläge 25 und 26 auf, gegen die Andrückelemente 27 und 28, welche auf dem Bestückungsrad befestigt sind, drücken. Zwischen den Andrückelementen 27, 28 und den Bremsbelegen 25, 26 sind die Interposer 2 in ausgerichteter Stellung eingeklemmt.

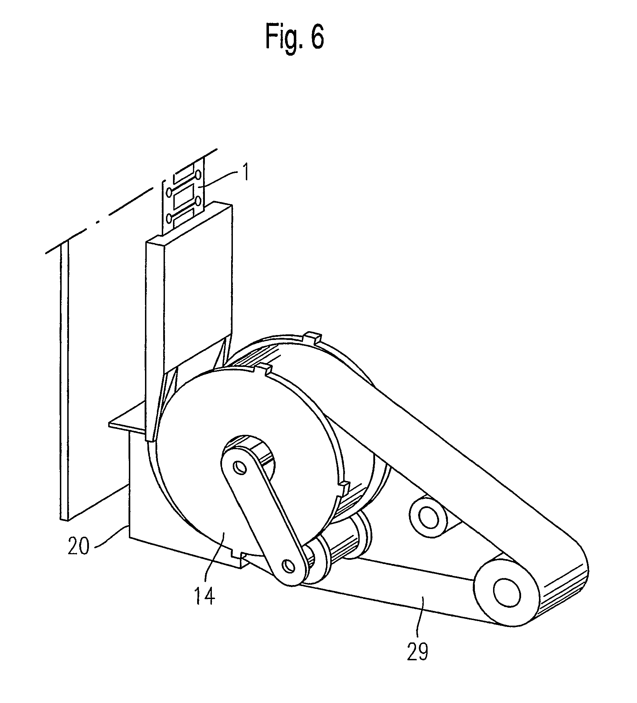

In Fig. 6 wird in einer perspektivischen Darstellung eine weitere Ausführungsform der Erfindung gezeigt. Wie dieser Darstellung zu entnehmen ist, ist das Bestückungsrad 14 mit einem Band 29 gekoppelt, welches die Beförderung der vereinzelten Interposer übernimmt.

Für die exakte Fixierung der Interposer auf dem bewegten Ablageelement ist eine genaue Lagebestimmung in X- und Y-Richtung der Interposer erforderlich. Eine derartige Ausrichtung wird durch Bewegung an definierten Körperkanten des Interposers realisiert. Für die Fixierung in Y-Richtung sind seitliche Führungen an den Bremsklotz 21 montiert. Der einzelne Interposer wird mit der Mitnehmerkralle 16 am Bestückungsrad in X-Richtung transportiert, wobei die Mitnehmerkralle immer an der definierten Transportkante 5 des Interposers anliegen muss. Ein Verrutschen des Interposers wird dadurch verhindert, dass die Andrückelemente 27, 28 den Interposer gegen die Bremsbeläge 25, 26 drücken.

Die Fixierung der einzelnen Interposer zwischen der Gegenrolle 24 und dem Bestückungsrad 14 erfolgt derart, dass der Druck auf die klebstoffhaftenden Befestigungspunkte 17 und somit eine Vorfixierung dadurch erreicht wird, indem der einzelne Interposer in einem Spalt zwischen dem auf der Gegenrolle 24 liegende Auflageelement 23 und den Stegen 18, 19 des Bestückungsrades 14 geschoben wird. Der Spalt ist einstellbar; wodurch eine Anpresskraft auf den Interposer veränderbar ist. Es ist zu beachten, dass der Interposer erst dann in den Spalt geschoben wird, nachdem er mittels des Bestückungsrads beschleunigt worden ist. Damit wird ein Schlupf zwischen den Interposer und dem Auflageelement 23 vermieden.

Sämtliche in den Anmeldungsunterlagen offenbarten Merkmale werden als erfindungswesentlich beansprucht, sofern sie einzeln oder in Kombination gegenüber dem Stand der Technik neu sind.

### Bezugszeichenliste

- 1: Interposerband
- 2: Interposer
- 2a: Längsseite des Interposer
- 3: Klebeflächen der Interposer
- 4: Bauteilbereich des Interposers
- 5: Transportkante der Interposer
- 6: Perforationslöcher
- 7: Haltestege
- 8: Zuführeinheit
- 8a: Oberfläche der Zuführeinheit
- 9: Transportrichtung des Interposerbandes
- 10: Stege, formschlüssige Elemente
- 11: Druckstempel
- 12: Schneideeinrichtung
- 13: Schneidemesser, Schneidrollen
- 13a: Verschieberichtung der Schneidemesser
- 14: Bestückungsrad
- 14a: Umfangsrandseite des Bestückungsrades
- 15: Achse
- 16: Mitnehmerkralle
- 17: Befestigungspunkte der Interposer
- 18, 19: Stege des Bestückungsrades
- 20: Bremseinrichtung
- 21: Bremsklotz
- 22: Heizelement
- 23: Auflageelement
- 24: Gegenrolle
- 25, 26: Bremsbelege
- 27,28: Andrückelemente
- 29: Band

## Patentansprüche

1. Vorrichtung zur Vereinzelung von in einem Modulbrückenband (1) oder Modulbrückenverbund angeordneten Modulbrücken (2) und zur Positionierung der vereinzelten Modulbrücken (2) auf einem Auflageelement (23),
**gekennzeichnet durch**
eine Trenneinrichtung (11,12,13) zum Trennen des Modulbrückenbandes (1) in dessen Randbereichen (7) zwischen jeweils zwei Modulbrücken (2) und ein Bestückungsrad (14) zum vereinzelten Aufnehmen und schlupffreien Transport der abgetrennten Modulbrücken (2) an dessen Umfangsrandseite (14a) und zum Ablegen der Modulbrücken (2) auf das sich bewegende Auflageelement (23) nach einer durchgeführten Drehbewegung des Bestückungsrades (14) um eine parallel zur Modulbrückenebene ausgerichtete Achse (15).

2. Vorrichtung nach Anspruch 1,
**dadurch gekennzeichnet, dass**
das Bestückungsrad (14) an seiner Umfangsrandseite (14a) voneinander beabstandete federbeaufschlagte Mitnehmerkrallen (16) zur Arretierung und Mitnahme einzelner Modulbrücken (2) auf der Umfangsrandseite (14a) aufweist.

3. Vorrichtung nach Anspruch 1 oder 2,
**dadurch gekennzeichnet, dass**
das Bestückungsrad (14) an seiner Umfangsrandseite (14a) eine Breitenabmessung aufweist, die einer Längenabmessung (2a) einer Modulbrücke (2) entspricht.

4. Vorrichtung nach einem der vorangegangenen Ansprüche,
**dadurch gekennzeichnet, dass**
das Bestückungsrad (14) an seiner Umfangsrandseite (14a) zumindestens in dem Bereich, in dem die Modulbrücken (2) aufgenommen sind, zwischen einem linksseitig und einem rechtsseitig angeordneten Steg (18, 19) einer Ausnehmungen zur Aufnahme von auf den Modulbrücken (2) angeordneten Bauelementen (4) aufweist.

5. Vorrichtung nach einem der vorangegangenen Ansprüche,
**dadurch gekennzeichnet, dass**
die Trenneinrichtung (11, 12, 13) ein senkrecht zur Modulbrückenbandebene verschiebbares Schneidmesser (13) oder Schneidrollen zum Durchtrennen des Modulbrückenbandes (8) in dessen Randbereichen (7) aufweist.

6. Vorrichtung nach Anspruch 5,
**dadurch gekennzeichnet, dass**
die Trenneinrichtung (11, 12, 13) mit einer Zuführeinheit (8) zum Zuführen des Modulbrückenbandes (1) zu dem Schneidmesser (13) verbunden ist.

7. Vorrichtung nach Anspruch 6,
**dadurch gekennzeichnet, dass**
die Trenneinrichtung (11, 12, 13) einen Druckstempel (11) zum Andrücken des Modulbrückenbandes (1) auf einer Oberfläche (8a) der Zuführeinheit (8) während eines Trennvorganges aufweist.

8. Vorrichtung nach Anspruch 6 oder 7,
**dadurch gekennzeichnet, dass**
die Zuführeinheit (8) Führungselemente zur seitlichen Führung des Modulbrückenbandes aufweist.

9. Vorrichtung nach einem der Ansprüche 6 - 8,
**dadurch gekennzeichnet, dass**
die Zuführeinheit (8) formschlüssige Elemente (10) zum Eingreifen in Durchgangsöffnungen (6) des Modulbrückenbandes (1) aufweist.

10. Vorrichtung nach einem der vorangegangenen Ansprüche,
**dadurch gekennzeichnet, dass**
die Trenneinrichtung (11,12,13) während eines Trennvorganges im Bezug auf das Bestückungsrad (14) kippbar ist.

11. Vorrichtung nach einem der vorangegangenen Ansprüche,
**dadurch gekennzeichnet, dass**
zwischen der Trenneinrichtung (11,12,13) und dem Auflageelement (23) eine an einem Teil der Umfangsrandseite (14a) des Bestückungsrads (14) anliegende Bremseinrichtung (20) zum Bremsen des sich drehenden Bestückungsrades (14) angeordnet ist.

12. Vorrichtung nach Anspruch 11,
**dadurch gekennzeichnet, dass**
das Bestückungsrad (14) unter Einwirkung der Bremseinrichtung (20) und eines Motors auf eine Drehgeschwindigkeit beschleunigbar ist, deren Umfangsgeschwindigkeit einer Geschwindigkeit des sich bewegenden Auflageelementes (23) entspricht.

13. Vorrichtung nach Anspruch 11 oder 12,
**dadurch gekennzeichnet, dass**
die Bremseinrichtung (20) ein Heizelement (22) zum Erwärmen von Kontaktldebestellen (3) der Modulbrücken (2) beinhaltet.

14. Vorrichtung nach einem der Ansprüche 11-13,
**dadurch gekennzeichnet, dass**
die Bremseinrichtung (20) an einem an der Umfangsrandseite (14a) des Bestückungsrads (14) anliegenden Bremsklotz (21) Führungselemente zum seitlichen Führen der Modulbrücken (2) während der Drehbewegung des Bestückungsrads (14) aufweist.

15. Vorrichtung nach Anspruch 14,
**dadurch gekennzeichnet, dass**
der Bremsklotz (21) zwei randseitig verlaufende Bremsbeläge (25, 26) aufweist, gegen die zwei komplementär ausgebildete an der Umfangsrandseite (14a) angeordnete Andrückelemente (27, 28) drücken, wobei zwischen den Andrückelementen (27, 28) und den Bremsbelägen (25, 26) die Modulbrücken (2) angeordnet sind.

16. Vorrichtung nach einem der vorangegangenen Ansprüche,
**gekennzeichnet durch**
eine Gegenrolle (24), die zum Fixieren der Modulbrücken (2) auf dem Auflageelement (23) auf einer dem Bestückungsrad (14) entgegengesetzten Seite des Auflageelementes (23) angeordnet ist.

17. Vorrichtung nach einem der vorangegangenen Ansprüche,
**gekennzeichnet durch**
eine Perforationseinrichtung zum Perforieren des Modulbrückenbandes (1) derart, dass die Modulbrücken (2) mit Ausnahme des Randbereiches (7) des Modulbrückenbandes (1) zur Minimierung einer Schneidkraft der Trenneinrichtung (11,12,13) voneinander getrennt sind.

18. Vorrichtung nach Anspruch 17,
**dadurch gekennzeichnet, dass**
die Perforationseinrichtung zur Schaffung definierter Interposerkörperkanten zum schlupffreien und genauen Transport der vereinzelten Interposer geeignet ist.

## Claims

1. Device for separating module bridges (2) arranged in a module bridge strip (1) or module bridge set and for positioning the separated module bridges (2) on a support element (23), **characterised by** a dividing device (11, 12, 13) for dividing the module bridge strip (1) in the edge regions (7) thereof between in each case two module bridges (2), and a placement wheel (14) for separately receiving and transporting in a slip-free manner the separated module bridges (2) on its peripheral edge side (14a) and for depositing the module bridges (2) onto the moving support element (23) after a rotational movement of the placement wheel (14) has been carried out about an axis (15) oriented parallel to the module bridge plane.

2. Device according to Claim 1, **characterised in that** the placement wheel (14) has, on its peripheral edge side (14a), spring-loaded carrier claws (16) which are spaced apart from one another and are provided for holding and carrying individual module bridges (2) on the peripheral edge side (14a).

3. Device according to Claim 1 or 2, **characterised in that** the placement wheel (14) has, on its peripheral edge side (14a), a width dimension which corresponds to a length dimension (2a) of a module bridge (2).

4. Device according to one of the preceding claims, **characterised in that** the placement wheel (14) has, on its peripheral edge side (14a), at least in the region in which the module bridges (2) are received, between a web (18, 19) arranged on the left side and on the right side, recesses for receiving components (4) arranged on the module bridges (2).

5. Device according to one of the preceding claims, **characterised in that** the dividing device (11, 12, 13) has a cutting blade (13) or cutting rollers which can be displaced perpendicular to the plane of the module bridge strip and is/are provided for cutting through the module bridge strip (1) in the edge regions (7) thereof.

6. Device according to Claim 5, **characterised in that** the dividing device (11, 12, 13) is connected to a feed unit (8) for feeding the module bridge strip (1) to the cutting blade (13).

7. Device according to Claim 6, **characterised in that** the dividing device (11, 12, 13) has a pressure ram (11) for pressing the module bridge strip (1) against a surface (8a) of the feed unit (8) during a dividing operation.

8. Device according to Claim 6 or 7, **characterised in that** the feed unit (8) has guide elements for laterally guiding the module bridge strip.

9. Device according to one of Claims 6 to 8, **characterised in that** the feed unit (8) has form-fitting elements (10) for engaging in through-apertures (6) of the module bridge strip (1).

10. Device according to one of the preceding claims, **characterised in that** the dividing device (11, 12, 13) can be tilted with respect to the placement wheel (14) during a dividing operation.

11. Device according to one of the preceding claims, **characterised in that** a brake device (20) which bears against part of the peripheral edge side (14a) of the placement wheel (14) and is provided for braking the rotating placement wheel (14) is arranged between the dividing device (11, 12, 13) and the support element (23).

12. Device according to Claim 11, **characterised in that** the placement wheel (14), under the effect of the brake device (20) and a motor, can be accelerated to a rotational speed at which the circumferential speed corresponds to a speed of the moving support element (23).

13. Device according to Claim 11 or 12, **characterised in that** the brake device (20) includes a heating element (22) for heating contact adhesive points (3) on the module bridges (2).

14. Device according to one of Claims 11 to 13, **characterised in that** the brake device (20) has, on a brake shoe (21) which bears against the peripheral edge side (14a) of the placement wheel (14), guide elements for laterally guiding the module bridges (2) during the rotational movement of the placement wheel (14).

15. Device according to Claim 14, **characterised in that** the brake shoe (21) has two brake linings (25, 26) running along the edge, against which two pressing elements (27, 28) of complementary shape press, said pressing elements being arranged on the peripheral edge side (14a), wherein the module bridges (2) are arranged between the pressing elements (27, 28) and the brake linings (25, 26).

16. Device according to one of the preceding claims, **characterised by** a counter-roller (24) which is arranged on a side of the support element (23) opposite the placement wheel (14) and is provided for fixing the module bridges (2) on the support element (23).

17. Device according to one of the preceding claims, **characterised by** a perforation device for perforating the module bridge strip (1) in such a way that the module bridges (2) are separated from one another with the exception of the edge region (7) of the module bridge strip (1), in order to minimise a cutting force of the dividing device (11, 12, 13).

18. Device according to Claim 17, **characterised in that** the perforation device is suitable for creating defined interposer edges for transporting the separated interposers in a slip-free and precise manner.

## Revendications

1. Dispositif pour séparer des ponts modules (2) agencés en bande de ponts modules (1) ou en assemblage de ponts modules et pour positionner les ponts modules séparés (2) sur un élément d'appui (23),
**caractérisé par**
un dispositif de séparation (11, 12, 13) pour séparer la bande de ponts modules (1) au niveau de ses zones de bord (7) entre, respectivement, deux ponts modules (2) et une roue d'équipement (14) pour la réception séparée et le transport sans glissement des ponts modules séparés (2) sur son rebord périphérique (14a) et pour le dépôt des ponts modules (2) sur l'élément d'appui mobile (23) après un mouvement de rotation exécuté par la roue d'équipement (14) autour d'un axe (15) dirigé parallèlement au plan des ponts modules.

2. Dispositif selon la revendication 1,
**caractérisé en ce que**
la roue d'équipement (14) présente sur son rebord périphérique (14a) des griffes d'entraînement (16) espacées l'une de l'autre et sollicitées par un ressort pour arrêter et entraîner des ponts modules individuels (2) sur le rebord périphérique (14a) .

3. Dispositif selon la revendication 1 ou 2,
**caractérisé en ce que**
la roue d'équipement (14) présente, sur son rebord périphérique (14a), une dimension en largeur qui correspond à une dimension en longueur (2a) d'un pont module (2).

4. Dispositif selon l'une quelconque des revendications précédentes,
**caractérisé en ce que**
la roue d'équipement (14) présente, sur son rebord périphérique (14a), au moins dans la zone où sont reçus les ponts modules (2), entre une arête (18, 19) agencée côté gauche et une arête agencée côté droit (18, 19) des évidements pour recevoir des composants (4) aménagés sur les ponts modules (2).

5. Dispositif selon l'une quelconque des revendications précédentes,
**caractérisé en ce que**
le dispositif de séparation (11, 12, 13) présente une lame de coupe (13) pouvant se déplacer perpendiculairement au plan de la bande de ponts modules ou des rouleaux de coupe pour séparer la bande de ponts modules (8) au niveau de ses zones de bord (7).

6. Dispositif selon la revendication 5,
**caractérisé en ce que**
le dispositif de séparation (11, 12, 13) est relié à une unité d'acheminement (8) pour acheminer la bande de ponts modules (1) à la lame de coupe (13).

7. Dispositif selon la revendication 6,
**caractérisé en ce que**
le dispositif de séparation (11, 12, 13) présente un vérin presseur (11) pour presser la bande de ponts modules (1) sur une surface (8a) de l'unité d'acheminement (8) pendant une opération de séparation.

8. Dispositif selon la revendication 6 ou 7,
**caractérisé en ce que**
l'unité d'acheminement (8) présente des éléments de guidage pour le guidage latéral de la bande de ponts modules.

9. Dispositif selon l'une quelconque des revendications 6 à 8,
**caractérisé en ce que**
l'unité d'acheminement (8) présente des éléments à complémentarité de forme (10) pour s'engager dans des ouvertures de passage (6) de la bande de ponts modules (1).

10. Dispositif selon l'une quelconque des revendications précédentes,
**caractérisé en ce que**
le dispositif de séparation (11, 12, 13) peut basculer pendant une opération de séparation par rapport à la roue d'équipement (14).

11. Dispositif selon l'une quelconque des revendications précédentes,
**caractérisé en ce que**,
entre le dispositif de séparation (11, 12, 13) et l'élément d'appui (23), est aménagé un dispositif de freinage (20), s'appliquant sur une partie du rebord périphérique (14a) de la roue d'équipement (14), pour freiner la roue d'équipement (14) en rotation.

12. Dispositif selon la revendication 11,
**caractérisé en ce que**
la roue d'équipement (14) peut être accélérée sous l'effet du dispositif de freinage (20) et d'un moteur à une vitesse de rotation, dont la vitesse périphérique correspond à une vitesse de l'élément d'appui (23) en mouvement.

13. Dispositif selon la revendication 11 ou 12,
**caractérisé en ce que**
le dispositif de freinage (20) contient un élément chauffant (22) pour chauffer les points adhésifs de contact (3) des ponts modules (2).

14. Dispositif selon l'une quelconque des revendications 11 à 13,
**caractérisé en ce que**
le dispositif de freinage (20) présente des éléments de guidage sur un sabot de frein (21) s'appliquant sur le rebord périphérique (14a) de la roue d'équipement (14) pour guider latéralement les ponts modules (2) pendant le mouvement de rotation de la roue d'équipement (14).

15. Dispositif selon la revendication 14,
**caractérisé en ce que**
le sabot de frein (21) présente deux garnitures de frein (25, 26) s'étendant sur le bord, contre lesquelles deux éléments de pression (27, 28) conformés de manière complémentaire et agencés sur le rebord périphérique (14a) exercent une pression, les ponts modules (2) étant disposés entre les éléments de pression (27, 28) et les garnitures de frein (25, 26).

16. Dispositif selon l'une quelconque des revendications précédentes,
**caractérisé par**
un contre-rouleau (24), qui est agencé pour fixer les ponts modules (2) sur l'élément d'appui (23), sur un côté de l'élément d'appui (23) opposé à la roue d'équipement (14).

17. Dispositif selon l'une quelconque des revendications précédentes,
**caractérisé par**
un dispositif de perforation pour perforer la bande de ponts modules (1) de sorte que les ponts modules (2), à l'exception de la zone de bord (7) de la bande de ponts modules (1), soient séparés l'un de l'autre pour minimiser une force de coupe du dispositif de séparation (11, 12, 13).

18. Dispositif selon la revendication 17,
**caractérisé en ce que**
le dispositif de perforation convient pour créer des arêtes de corps intercalaires définies pour permettre le transport précis sans glissement des corps intercalaires séparés.
